# EUROPÄISCHE PATENTSCHRIFT

(11) **EP 2 994 934 B1**
(45) Veröffentlichungstag und Bekanntmachung des Hinweises auf die Patenterteilung: **21.10.2020**
(21) Anmeldenummer: 14716279.6
(22) Anmeldetag: 04.04.2014
(51) Int. Cl.: H01L 21/50, H01L 41/23, H01L 41/053, H01L 41/083, H01C 7/102, H01G 4/30, H01G 4/06, H01G 4/22

(54) **ELEKTRONISCHES BAUELEMENT UND VERFAHREN ZU DESSEN PASSIVIERUNG**
ELECTRONIC COMPONENT AND METHOD FOR THE PASSIVATION THEREOF
COMPOSANT ÉLECTRONIQUE ET PROCÉDÉ DE PASSIVATION CORRESPONDANT

(30) Priorität: 06.05.2013 DE 102013104621
(43) Veröffentlichungstag der Anmeldung: 16.03.2016
(73) Patentinhaber: TDK Electronics AG, 81671 München (DE)
(72) Erfinder: DERNOVSEK, Oliver, A-8501 Lieboch (AT); STAHL, Michael, A-8544 Pölfing Brunn (AT)
(74) Vertreter: Epping - Hermann - Fischer
(86) Internationale Anmeldenummer: PCT/EP2014/056832
(87) Internationale Veröffentlichungsnummer: WO 2014/180608

(56) Entgegenhaltungen:
- DE-U1- 29 904 858
- JP-A- 2005 051 195
- US-A- 4 963 396
- US-A1- 2010 020 465
- US-A1- 2011 273 056
- US-A1- 2012 161 576
- US-A1- 2012 245 016

## Beschreibung

Die vorliegende Erfindung betrifft ein elektronisches Bauelement und ein Verfahren zur Passivierung des elektronischen Bauelements.

US 2011/273056 A1 beschreibt die Herstellung eines keramischen elektronischen Bauelements, bei dem das Bauelement mit einem Öl-abweisenden Mittel behandelt wird, das einen Film auf der Oberfläche des keramischen Elements bildet. DE 29904858 U1 betrifft eine feinporöse, offenporige Keramik, die als Wasserspeicher genutzt wird. US 2012/245016 A1 eine Materialzusammensetzung mit einer hohen Dielektrizitätszahl, welches mit einem Fluid imprägniert wird.

Eine zu lösende Aufgabe ist es, ein verbessertes elektronisches Bauelement sowie ein Verfahren zu dessen Passivierung anzugeben.

Die Aufgabe wird durch das elektronische Bauelement mit den Merkmalen des Patentanspruchs 1 sowie durch das Verfahren mit den Merkmalen des Patentanspruchs 9 gelöst. Vorteilhafte Ausgestaltungen und Weiterbildungen sind Gegenstand der abhängigen Patentansprüche.

Ein vorgeschlagenes elektronisches Bauelement umfasst einen Grundkörper, der ein poröses Material mit Oberflächenporen an einer Oberfläche des Grundkörpers aufweist. In den Oberflächenporen ist eine Passivierungsflüssigkeit angeordnet.

Bei der Oberfläche handelt es sich vorzugsweise um eine Außen- oder Hüllfläche des Grundkörpers. Die Passivierungsflüssigkeit ist vorzugsweise dauerhaft in den Oberflächenporen des Grundkörpers angeordnet.

Die Passivierungsflüssigkeit ist vorzugsweise nicht korrosiv.

Bei den Oberflächenporen handelt es sich um Sinterporen, welche im Zuge eines Sintervorgangs des den Grundkörper bildenden Materials entstehen. Die Durchmesser der Oberflächenporen können beispielsweise im Nanometerbereich liegen.

Die Oberflächenporen sind vorzugsweise so beschaffen und der Dampfdruck der Passivierungsflüssigkeit ist vorzugsweise so gewählt, dass durch einfache Wasch- und/oder Trockenprozesse die Passivierungsflüssigkeit nicht aus den Poren entfernt werden oder verdampfen kann.

Mit "Passivierung" ist vorliegend die spontane oder gezielte Erzeugung einer Passivierungs- oder Schutzschicht an der Oberfläche des Grundkörpers und/oder in den Oberflächenporen gemeint. Die Passivierungs- oder Schutzschicht schützt die Oberflächenporen und/oder den Grundkörper vor einem Eindringen korrosiver oder für den Grundkörper schädigender Medien oder Stoffe in die Oberflächenporen beziehungsweise in das Innere des Grundkörpers.

In einer bevorzugten Ausgestaltung verlangsamt oder verhindert die Präsenz der Passivierungsflüssigkeit in den Oberflächenporen die Reaktionskinetik von elektromechanischen Reaktionen und/oder die Entstehung von Mikrorissen im Grundkörper.

Durch die Präsenz der Passivierungsflüssigkeit in den Oberflächenporen kann mit Vorteil einer Korrosion des Materials des Grundkörpers vorgebeugt beziehungsweise diese verhindert oder verlangsamt werden. Vorzugsweise können mit Hilfe der Passivierungsflüssigkeit korrosive oder elektromechanische Reaktionen und/oder die Entstehung von Mikrorissen innerhalb des Materials des Grundkörpers, insbesondere unter Anwendung oder unter den Bedingungen von Feuchte, Wärme und/oder elektrischer Spannung, verhindert oder eingeschränkt werden. Die Mikrorisse und/oder die elektromechanischen Reaktionen können beispielsweise zu einer Degradation der elektrischen oder elektromechanischen Eigenschaften des Materials des Grundkörpers und damit zu einem Ausfall oder einer fehlerhaften Funktion des elektronischen Bauelements führen. Ein Ausfall oder eine fehlerhafte Funktion kann, insbesondere bei sicherheitsrelevanten Anwendungen und/oder automotiven Anwendungen des elektronischen Bauelements, weitreichende oder katastrophale Folgen haben.

Mit der Passivierung kann der Grundkörper derart ausgebildet werden, dass die Dichte statistischer Fehlstellen oder Risse im Material des Grundkörpers im ppb-Bereich ("ppb" englisch für "parts per billion", zu deutsch "Teile pro Milliarde") oder darunter liegt. Bei den statistischen Fehlstellen kann es sich auch um Poren oder porenartige Fehlstellen im Inneren des Grundkörpers handeln.

Der Grundkörper weist eine Keramik auf. Die Keramik ist eine gesinterte Keramik.

In einer bevorzugten Ausgestaltung ist das elektronische Bauelement ein Vielschichtbauelement, beispielsweise ein Varistor, ein piezoelektrisches Bauelement oder ein Kondensator.

Oberflächenbereiche des Grundkörpers, in denen sich keine Poren befinden, sind frei von der Passivierungsflüssigkeit. In den genannten Oberflächenbereichen des Grundkörpers kann die Passivierungsflüssigkeit durch Wasch- und/oder Trockenprozesse entfernt worden beziehungsweise verdampft sein. Die genannten Oberflächenbereiche sind jedoch aufgrund ihrer Oberflächenbeschaffenheit weniger anfällig gegenüber korrosiven Medien, das heißt, dass ebenfalls die korrosiven Medien beispielsweise leichter durch Waschprozesse von den Oberflächenbereichen entfernt werden können.

Die in den Oberflächenporen angeordnete Passivierungsflüssigkeit verhindert oder erschwert das Eindringen von Fremdstoffen, beispielweise korrosiven Stoffen, wie Nickel und/oder Zinn umfassenden Elektrolytlösungen, alkalihaltigen Lötflussmitteln, wie Natrium- oder Kalium-Laugen und/oder Schleifschutzmitteln über die Poren in den Grundkörper. Gemäß dieser Ausgestaltung kann das elektronische Bauelement mit Vorteil mit einem Verfahren hergestellt werden, welche die Behandlung des elektronischen Bauelements oder von Ausgangskomponenten des elektronischen Bauelements mit den genannten korrosiven Stoffen erfordert, ohne dass es zu einer signifikanten Korrosion, Degradation oder Schädigung des elektronischen Bauelements oder seiner Ausgangskomponenten kommt.

Das genannte Eindringen oder die Infiltration der genannten korrosiven Stoffe in die Oberflächenporen kann, ohne eine Passivierung des Grundkörpers, beispielsweise während der Herstellung des elektronischen Bauelements, spontan über die Gasphase oder die flüssige Phase erfolgen.

In einer bevorzugten Ausgestaltung ist die Passivierungsflüssigkeit eine Inertlösung oder eine quasi inerte Lösung, beispielsweise eine Lösung mit niedriger Ionenkonzentration und/oder einem niedrigen elektrischen spezifischen Widerstand. Beispielsweise weist die Passivierungsflüssigkeit deionisiertes Wasser oder ein unpolares Lösungsmittel auf. Durch diese Ausgestaltung kann mit Vorteil eine Korrosion oder Degradation des elektronischen Bauelements durch elektromechanische Beanspruchungen in Gegenwart einer beispielsweise feuchten oder nassen Umgebung, Wärme und/oder elektrischer Spannung verhindert oder verlangsamt werden.

In einer bevorzugten Ausgestaltung weist die Passivierungsflüssigkeit einen spezifischen elektrischen Widerstand zwischen 10 und 1000 kΩcm auf.

In einer alternativen Ausgestaltung weist die Passivierungsflüssigkeit einen spezifischen elektrischen Widerstand oberhalb von 10 kΩcm auf.

In einer bevorzugten Ausgestaltung sind in dem Grundkörper Innenelektroden angeordnet, wobei die Innenelektroden elektrisch voneinander getrennt sind. Die Innenelektroden können dabei alternierend an zwei gegenüberliegenden Stirnseiten des Grundkörpers angrenzen und/oder von diesen Stirnseiten, beispielsweise für eine Kontaktierung zu Außenelektroden, zugänglich sein.

Der Grundkörper ist mit Außenelektroden versehen, wobei die Außenelektroden elektrisch voneinander getrennt sind und jede Außenelektrode mit mehreren Innenelektroden elektrisch leitfähig verbunden ist.

Dadurch wird mit Vorteil eine Ausführung des elektronischen Bauelements als Vielschichtbauelement und die Ausnutzung der damit verbundenen Vorteile ermöglicht. Die genannten Vorteile betreffen, beispielsweise im Falle von piezoelektrischen Bauelementen, eine größere Auslenkung im Betrieb.

Es wird weiterhin ein Verfahren zur Passivierung eines ein poröses Material aufweisenden Grundkörpers angegeben. Das oben beschriebene elektronische Bauelement oder ein Grundkörper dieses Bauelements ist vorzugsweise mittels des hier beschriebenen Verfahrens passiviert.

Insbesondere können sich sämtliche für das Verfahren zur Passivierung offenbarten Merkmale auch auf das oben beschriebene elektronische Bauelement beziehen und umgekehrt.

Das Verfahren zur Passivierung umfasst das Bereitstellen des Grundkörpers. Das Verfahren umfasst weiterhin das Aussetzen von Oberflächenporen des porösen Materials des Grundkörpers einer Passivierungsflüssigkeit, wobei die Passivierungsflüssigkeit in die Oberflächenporen eindringt und dort verbleibt.

Ein Vorteil des Verfahren zur Passivierung betrifft die Möglichkeit auf aufwendige Flüssigphasen- und Gasphasenprozesse, wodurch schützende Glaskeramiken oder metallische Schichten auf den Grundkörper oder das Bauteil aufgebracht werden können, um dieses vor dem Eindringen von korrosiven Stoffen zu schützen, zu verzichten.

Weiterhin kann auf die komplexe Herstellung hochdichter Keramiken, wobei keine oder sehr wenige offen zugängliche Oberflächenporen, beziehungsweise Risse entstehen, verzichtet werden.

Ebenfalls wird durch die Verhinderung von Mikrorissen die Lebensdauer der elektromechanisch beanspruchten elektronischen Bauteile deutlich gesteigert.

Die Infiltration der Oberflächenporen mit der Passivierungsflüssigkeit ist weiterhin kostengünstig, wodurch das elektronische Bauelement mit Vorteil mit geringen Kosten hergestellt werden kann.

Obwohl die Oberflächenporen zweckmäßigerweise von einer Umgebung des Grundkörpers zugänglich sind, verbleibt die Passivierungsflüssigkeit mit Vorteil in den Oberflächenporen, da sich aufgrund der Geometrie der Oberflächenporen mit Durchmessern, die beispielsweise im Bereich einiger Nanometer liegen, nur sehr langsam oder nicht signifikant oder nicht messbar langsam verdampfen.

Das Aussetzen der Oberflächenporen erfolgt vorzugsweise über ein Eintauchen des Grundkörpers in die Passivierungsflüssigkeit. Alternativ kann das Aussetzen der Oberflächen der Passivierungsflüssigkeit auch durch andere Verfahren, beispielsweise durch ein Benetzen der Oberfläche des Grundkörpers mit der Passivierungsflüssigkeit, erfolgen.

In einer bevorzugten Ausgestaltung des Verfahrens werden die Oberflächenporen zur Passivierung der Oberfläche des Grundkörpers der Passivierungsflüssigkeit ausgesetzt.

In einer bevorzugten Ausgestaltung des Verfahrens werden die Oberflächenporen der Passivierungsflüssigkeit unter den Bedingungen des Umgebungsdrucks und/oder ohne Anlegen eines externen Drucks ausgesetzt. Bei dem Aussetzen der Oberflächenporen der Passivierungsflüssigkeit kann es sich um eine spontane Infiltration der Poren mit der Passivierungsflüssigkeit handeln. Das Aussetzen der Oberflächenporen der Passivierungsflüssigkeit kann unter Standarddruckbedingungen erfolgen. Durch diese Ausgestaltung kann mit Vorteil auf weitere Komponenten, welche eine Infiltration, beispielsweise unter erhöhtem Druck, ermöglichen, verzichtet und der Grundkörper demnach besonders einfach und kostengünstig passiviert werden.

In einer alternativen Ausgestaltung des Verfahrens werden die Oberflächenporen der Passivierungsflüssigkeit unter erhöhtem externen Druck ausgesetzt. Gemäß dieser Ausgestaltung können die Oberflächenporen mit Vorteil besonders einfach von der Passivierungsflüssigkeit infiltriert werden.

In einer bevorzugten Ausgestaltung des Verfahrens werden die Oberflächenporen der Passivierungsflüssigkeit bei Raumtemperatur ausgesetzt. Durch diese Ausgestaltung kann mit Vorteil auf eine Einrichtung zum Heizen oder Beheizen des Grundkörpers während der Passivierung verzichtet werden. Außerdem können so mit Vorteil thermisch verursachte Schädigungen, beispielsweise des Grundkörpers, verhindert werden.

Es wird weiterhin ein Verfahren zur Herstellung des elektronischen Bauelements mit folgenden Schritten angegeben. Das Verfahren zur Herstellung umfasst die Sinterung eines für den Grundkörper des Bauelements vorgesehenen Grünlings, um den Grundkörper zu bilden, wobei der Grünling ein gesintertes, poröses Material aufweist. Weiterhin umfasst das Verfahren zur Herstellung das Versehen des Grundkörpers mit einer oder mehreren Außenelektroden. Weiterhin umfasst das Verfahren zur Herstellung die Passivierung des mit der Außenelektrode versehenen porösen Grundkörpers gemäß dem oben beschriebenen Verfahren zur Passivierung. Weiterhin umfasst das Verfahren zur Herstellung das galvanische Behandeln des mit der oder den Außenelektroden versehenen Grundkörpers. Weiterhin umfasst das Verfahren zur Herstellung das Fertigstellen des elektronischen Bauelements.

Das oben beschriebene elektronische Bauelement oder ein Grundkörper dieses Bauelements ist vorzugsweise mittels des hier beschriebenen Verfahrens zur Herstellung hergestellt.

In einer bevorzugten Ausgestaltung des Verfahrens zur Passivierung wird der Grundkörper bei Temperaturen zwischen 700 °C und 800 °C mit der Außenelektrode versehen.

In einer bevorzugten Ausgestaltung wird das Galvanisieren des Grundkörpers in einer, beispielsweise Nickel und Zinn enthaltenden, Elektrolytlösung durchgeführt. Der Zweck der Galvanisierung kann eine zu dem Versehen des Grundkörpers mit einer oder mehreren Außenelektroden zusätzliche oder unterstützende Metallisierung des Grundkörpers, eine Abschirmung, beispielsweise gegen elektrische Felder, oder eine kontaktbildende Metallisierung, sein.

Das Verfahren zur Herstellung kann weiterhin eine Oberflächenaktivierung des Materials der Außenelektrode, beispielsweise mittels "Fluxen" umfassen. Beim "Fluxen" kann eine Oberfläche des Materials der Außenelektrode mit einem Flussmittel, beispielsweise alkalischen Lösungen, behandelt und/oder aktiviert werden.

Das Verfahren zur Herstellung kann weiterhin das Behandeln des Grundkörpers, des galvanisierten Grundkörpers und/oder der Außenelektrode(n) mit beispielsweise alkalihaltigen Lötflussmitteln, wie Natrium- oder Kalium-Laugen und/oder Schleifschutzmitteln, umfassen.

In einer bevorzugten Ausgestaltung wird der Grundkörper in Oberflächenbereichen des Grundkörpers, in denen sich keine Poren befinden, beispielsweise bei 120 °C in einem Trockenschrank, getrocknet. Der Dampfdruck der Passivierungsflüssigkeit ist dabei vorzugsweise so gewählt, dass die Passivierungsflüssigkeit während des Trocknens in den Oberflächenporen verbleibt und nicht verdampft.

Weitere Vorteile, vorteilhafte Ausgestaltungen und Zweckmäßigkeiten der Erfindung ergeben sich aus der folgenden Beschreibung der Ausführungsbeispiele in Verbindung mit den Figuren.
- Figur 1: zeigt schematisch einen Querschnitt durch einen Grundkörper für ein elektronisches Bauelement.
- Figur 2: zeigt schematisch einen Querschnitt durch das elektronische Bauelement.

Gleiche, gleichartige und gleich wirkende Elemente sind in den Figuren mit gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

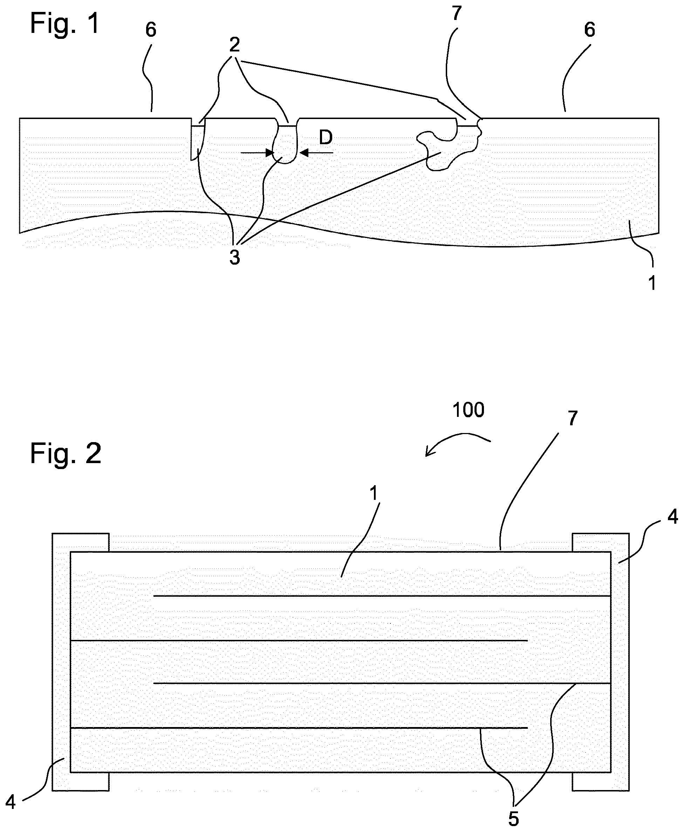

Figur 1 zeigt einen schematischen Querschnitt durch einen Grundkörper 1. Bei dem Grundkörper 1 handelt es sich um eine Keramik. Der Grundkörper weist eine Oberfläche 7 auf. Beispielhaft sind drei Oberflächenporen 2 des Grundkörpers 1 dargestellt. Die Oberflächenporen 2 können Sinterporen sein, welche bei einer Sinterung des den Grundkörper bildenden Materials entstanden sind. Die Größe und die Form der Oberflächenporen können demgemäß statistisch variieren. Die Durchmesser D der Oberflächenporen liegen vorzugsweise im Nanometerbereich.

In den Oberflächenporen 2 ist jeweils eine Passivierungsflüssigkeit 3 angeordnet. Der Grundkörper 1 weist weiterhin Oberflächenbereiche 6 auf, in denen sich keine Poren befinden. Die Oberflächenbereiche sind frei von der Passivierungsflüssigkeit 3.

Bei der Passivierungsflüssigkeit kann es sich vorzugsweise um eine Inertlösung oder quasi inerte Lösung, beispielsweise deionisiertes Wasser oder ein unpolares Lösungsmittel aufweisend, handeln.

Die Passivierungsflüssigkeit verhindert das Eindringen von korrosiven Stoffen, beispielsweise Nickel und/oder Zinn umfassenden Elektrolytlösungen, alkalihaltigen Lötflussmitteln, wie Natrium- oder Kalium-Laugen und/oder Schleifschutzmitteln über die Oberflächenporen 3 in den Grundkörper 1 oder erschwert dieses.

Bei den genannten korrosiven Stoffen kann es sich auch um saure oder basische Lösungen, die während des Herstellungsprozesses angewendet werden, handeln.

Weiterhin erschwert oder verlangsamt die Präsenz der Passivierungsflüssigkeit in den Oberflächenporen 3 vorzugsweise die Reaktionskinetik von elektromechanischen Reaktionen und/oder die Entstehung von Mikrorissen im Grundkörper 1. Die Passivierungsflüssigkeit 3 passiviert vorzugsweise eine Oberfläche 7 des Grundkörpers 1.

Die Passivierungsflüssigkeit 3 dringt vorzugsweise während eines Aussetzens, insbesondere Eintauchens des Grundkörpers 1 in die Passivierungsflüssigkeit 3 in die Oberflächenporen 2 ein. Ebenso kann die Passivierungsflüssigkeit 3 durch ein Benetzen des Grundkörpers 1 mit der Passivierungsflüssigkeit 3 in die Oberflächenporen 2 gelangen. Durch die Größe der Oberflächenporen und die Wahl des Dampfdrucks der Passivierungsflüssigkeit 3 verbleibt die Passivierungsflüssigkeit 3 vorzugsweise innerhalb der Oberflächenporen, auch für den Fall, dass der Grundkörper 1 nach dem Aussetzen der Oberflächenporen 2 mit der Passivierungsflüssigkeit 3 getrocknet oder gewaschen wurde.

Das Aussetzen erfolgt vorzugsweise durch sogenannte spontane Infiltration der Passivierungsflüssigkeit 3, wobei vorzugsweise kein externer Druck und keine erhöhten Temperaturen notwendig sind.

Vorzugsweise erfolgt das Eindringen der Passivierungsflüssigkeit 3 in die Oberflächenporen 2 durch spontane Infiltration unter Umgebungsdruckbedingungen bei Raumtemperatur.

Figur 2 zeigt einen schematischen Querschnitt durch ein elektronisches Bauelement 100. Das elektronische Bauelement 100 weist den Grundkörper 1 auf. Weiterhin weist das elektronische Bauelement 100 Innenelektroden 5 auf. Die Innenelektroden 5 sind innerhalb des Grundkörpers 1 angeordnet. Die Innenelektroden 5 sind weiterhin überlappend oder ineinandergreifend angeordnet. Das elektronische Bauelement 100 weist weiterhin Außenelektroden 4 auf. Jeweils eine Außenelektrode 4 ist an einer Stirnseite des elektronischen Bauelements 100 angeordnet. Die Außenelektroden 4 sind elektrisch voneinander getrennt und mit jeweils zwei beispielhaften Innenelektroden 5 elektrisch leitfähig verbunden.

Das elektronische Bauelement 100 ist vorzugsweise ein Vielschichtbauelement, beispielsweise ein Varistor, ein piezoelektrisches Bauelement oder ein Kondensator.

Eine Herstellung des elektronischen Bauelements kann vorzugsweise die Schritte der Sinterung des für den Grundkörper 1 vorgesehenen Materials zu dem Grundkörper, das Versehen des Grundkörpers 1 mit den Außenelektroden 4, die Passivierung des mit den Außenelektroden 4 versehenen Grundkörpers 1, wie oben beschrieben, das Galvanisieren des Grundkörpers 1 und das Fertigstellen des elektronischen Bauelements, umfassen.

Das Galvanisieren des Grundkörpers erfolgt vorzugsweise in einer beispielsweise Nickel oder Zinn enthaltenden Elektrolytlösung.

Das elektronische Bauelement 100 kann beispielsweise ein Vielschichtvaristor der Bauform 0506 oder ein Hochleistungspiezoaktor sein, bei denen die Außenelektroden bei 780 °C eingebrannt wurden. Nach dem Versehen der Außenelektrode kann das elektronische Bauelement bei Raumtemperatur zur Infiltration mit der Passivierungsflüssigkeit in deionisiertes Wasser getaucht und anschließend bei 120 °C in einem Trockenschrank getrocknet werden.

Das elektronische Bauelement 100 kann ebenfalls ein EPC4-Piezoaktor oder ein Kupfer-Piezoaktor auf der Basis poröser Sollbruchstellen sein, bei denen die Außenelektroden bei 740 °C eingebrannt wurden. Anschließend kann das elektronische Bauelement "heißgepolt" und anschließend zur Infiltration in die Passivierungsflüssigkeit 3 getaucht und bei 120 °C getrocknet werden. In diesem Fall kann galvanisch eine Oberflächenaktivierung der Außenelektroden mittels "Fluxen" oder Feuerverzinken erfolgen und das elektronische Bauelement 100 anschließend in Coloradol und Wasser gewaschen und getrocknet werden.

Ein Vorteil gegenüber nicht passivierten elektronischen Bauelementen besteht vorliegend darin, dass Rückstände der genannten korrosiven Stoffe, welche bei nicht erfindungsgemäß passivierten Bauteilen bereits auf ppm-Niveau ("ppm" englisch für "parts per million" zu deutsch "Teile pro Million") vorliegen können, über die Entstehung von Mikrorissen oder schädigenden elektrochemischen Reaktionen zu einer Degradation des Bauteils führen können.

Durch das vorgestellte Passivierungsverfahren kann mit Vorteil insbesondere auf die Reinigung des Grundkörpers, beispielsweise während der Herstellung des elektronischen Bauteils, bei Temperaturen von weit über 200 °C und auf entsprechende Vakuumprozesse, welche industriell zur massiven zeitlichen und finanziellen Aufwendungen führen, verzichtet werden. Erhöhte Temperaturen können zu einer merklichen Verschlechterung der elektrischen Eigenschaften der elektronischen Bauteile führen. Im Speziellen können sich Lötstellen ablösen oder thermische Risse bilden. Des Weiteren führen Temperaturen oberhalb der Curie-Temperatur im Falle von piezoelektrischen Bauteilen zu merklicher dielektrischer Depolarisation.

Die Erfindung ist nicht durch die Beschreibung anhand der Ausführungsbeispiele beschränkt. Vielmehr wird die Erfindung durch die beigefügten Ansprüche definiert.

### Bezugszeichenliste

- 1: Grundkörper
- 2: Oberflächenporen
- 3: Passivierungsflüssigkeit
- 4: Außenelektrode
- 5: Innenelektrode
- 6: Oberflächenbereiche
- 7: Oberfläche

- 100: Elektronisches Bauelement

## Patentansprüche

1. Elektronisches Bauelement (100) mit einem Grundkörper (1), der ein poröses Material mit Oberflächenporen (2) an einer Oberfläche (7) des Grundkörpers (1) aufweist,
wobei in den Oberflächenporen (2) eine Passivierungsflüssigkeit (3) angeordnet ist,
wobei Oberflächenbereiche (6) des Grundkörpers (1), in denen sich keine Oberflächenporen (2) befinden, frei von der Passivierungsflüssigkeit (3) sind,
und wobei die Passivierungsflüssigkeit die Oberflächenporen (2) und/oder den Grundkörper (1) vor einem Eindringen korrosiver oder für den Grundkörper (1) schädigender Medien oder Stoffe in die Oberflächenporen (2) beziehungsweise in das Innere des Grundkörpers (1) schützt, wobei der Grundkörper (1) eine gesinterte Keramik ist und wobei der Grundkörper (1) mit einer Außenelektrode (4) versehen ist.

2. Elektronisches Bauelement (100) nach Anspruch 1, bei dem die Durchmesser der Oberflächenporen (2) im Nanometerbereich liegen.

3. Elektronisches Bauelement (100) nach mindestens einem der vorhergehenden Ansprüche,
wobei die in den Oberflächenporen (2) angeordnete Passivierungsflüssigkeit (3) das Eindringen von Fremdstoffen, beispielsweise Ni und/oder Sn umfassenden Elektrolytlösungen, alkalihaltigen Lötflussmitteln, wie Na- oder K-Laugen und/oder Schleifschutzmitteln, über die Oberflächenporen (2) in den Grundkörper (1) verhindert oder erschwert.

4. Elektronisches Bauelement (100) nach mindestens einem der vorhergehenden Ansprüche,
wobei die Passivierungsflüssigkeit (3) eine Inertlösung oder eine quasi inerte Lösung, beispielsweise deionisiertes Wasser oder ein unpolares Lösungsmittel aufweisend, ist.

5. Elektronisches Bauelement (100) nach mindestens einem der vorhergehenden Ansprüche,
wobei die Passivierungsflüssigkeit (3) einen spezifischen elektrischen Widerstand zwischen 10 und 1000 kΩcm aufweist.

6. Elektronisches Bauelement (100) nach mindestens einem der vorhergehenden Ansprüche,
wobei in dem Grundkörper (1) Innenelektroden (5) angeordnet sind und wobei die Innenelektroden (5) elektrisch voneinander getrennt sind.

7. Elektronisches Bauelement (100) nach mindestens einem der vorhergehenden Ansprüche,
wobei der Grundkörper (1) mit Außenelektroden (4) versehen ist und wobei die Außenelektroden (4) elektrisch voneinander getrennt sind und jede Außenelektrode (4) mit mehreren Innenelektroden (5) elektrisch leitfähig verbunden ist.

8. Elektronisches Bauelement (100) nach mindestens einem der vorhergehenden Ansprüche,
welches ein Vielschichtbauelement, beispielsweise ein Varistor, ein piezoelektrisches Bauelement oder ein Kondensator ist.

9. Verfahren zur Herstellung eines elektronischen Bauelements (100) mit folgenden Schritten:
- Sinterung eines für einen Grundkörper (1) des Bauelements vorgesehenen Grünlings, um den Grundkörper (1) zu bilden, wobei der Grünling ein gesintertes, poröses Material aufweist,
- Versehen des Grundkörpers (1) mit einer Außenelektrode (4),
- Passivierung des mit der Außenelektrode (4) versehenen, porösen Grundkörpers (1) durch Bereitstellen des Grundkörpers (1), und Aussetzen von Oberflächenporen (2) des porösen Materials des Grundkörpers (1) einer Passivierungsflüssigkeit (3), wobei die Passivierungsflüssigkeit (3) in die Oberflächenporen (2) eindringt und dort verbleibt,
- galvanisches Behandeln des mit der Außenelektrode versehenen Grundkörpers (1), Oberflächenaktivierung des Materials der Außenelektrode durch Behandeln einer Oberfläche des Materials der Außenelektrode mit einem Flussmittel, oder Behandeln des Grundkörpers (1), des galvanisierten Grundkörpers (1) und/oder der Außenelektrode mit Lötflussmitteln und/oder Schleifschutzmitteln,
- Fertigstellen des elektronischen Bauelements (100).

10. Verfahren zur Herstellung nach Anspruch 9,
wobei das galvanische Behandeln des mit der Außenelektrode versehenen Grundkörpers (1) in einer, beispielsweise Nickel und Zinn enthaltenden, Elektrolytlösung durchgeführt wird.

11. Verfahren nach Anspruch 9 oder 10,
wobei die Oberflächenporen (2) der Passivierungsflüssigkeit (3) unter Bedingungen des Umgebungsdrucks ohne Anlegen eines externen Drucks ausgesetzt werden.

12. Verfahren nach einem der Ansprüche 9 bis 11,
wobei die Oberflächenporen (2) der Passivierungsflüssigkeit (3) bei Raumtemperatur ausgesetzt werden.

## Claims

1. Electronic device (100) with a main body (1), having a porous material with surface pores (2) at a surface (7) of the main body (1),
wherein a passivation liquid (3) is arranged in the surface pores (2),
wherein surface regions (6) of the main body (1) in which there are no surface pores (2) are free of the passivation liquid (3), and wherein the passivation liquid protects the surface pores (2) and/or the main body (1) from the penetration of corrosive media or substances or media or substances harmful to the main body (1) into the surface pores (2) and/or into the interior of the main body (1), wherein the main body (1) is a sintered ceramic and wherein the main body (1) is provided with an external electrode (4).

2. Electronic device (100) according to Claim 1, in which the diameters of the surface pores (2) lie in the nanometer range.

3. Electronic device (100) according to at least one of the preceding claims,
wherein the passivation liquid (3) arranged in the surface pores (2) prevents or complicates the penetration of foreign substances, for example electrolyte solutions comprising Ni and/or Sn, alkali metal-containing soldering fluxes, such as Na or K alkalies and/or grinding protection media, via the surface pores (2) into the main body (1).

4. Electronic device (100) according to at least one of the preceding claims,
wherein the passivation liquid (3) is an inert solution or a quasi inert solution, for example comprising deionized water or a nonpolar solvent.

5. Electronic device (100) according to at least one of the preceding claims,
wherein the passivation liquid (3) has a specific electrical resistance of between 10 and 1000 kΩcm.

6. Electronic device (100) according to at least one of the preceding claims,
wherein internal electrodes (5) are arranged in the main body (1) and wherein the internal electrodes (5) are electrically isolated from one another.

7. Electronic device (100) according to at least one of the preceding claims,
wherein the main body (1) is provided with external electrodes (4) and wherein the external electrodes (4) are electrically isolated from one another and each external electrode (4) is connected electrically conductively with a plurality of internal electrodes (5).

8. Electronic device (100) according to at least one of the preceding claims,
which is a multilayer device, for example a varistor, a piezoelectric device or a capacitor.

9. Method for producing an electronic device (100) having the following steps:
- sintering a green compact provided for a main body (1) of the device, in order to form the main body (1), wherein the green compact comprises a sintered, porous material,
- providing the main body (1) with an external electrode (4),
- passivating the porous main body (1) provided with the external electrode (4) by providing the main body (1) and exposing surface pores (2) of the porous material of the main body (1) to a passivation liquid (3), wherein the passivation liquid (3) penetrates into the surface pores (2) and remains there,
- electroplating the main body (1) provided with the external electrode, surface activating the material of the external electrode by treating a surface of the material of the external electrode with a flux, or treating the main body (1), the electroplated main body (1) and/or the external electrode with soldering fluxes and/or grinding protection media,
- finishing the electronic device (100).

10. Production method according to Claim 9,
wherein the electroplating of the main body (1) provided with the external electrode is performed in an electrolyte solution containing for example nickel and tin.

11. Method according to Claim 9 or 10,
wherein the surface pores (2) are exposed to the passivation liquid (3) under ambient pressure conditions without application of an external pressure.

12. Method according to one of Claims 9 to 11,
wherein the surface pores (2) are exposed to the passivation liquid (3) at room temperature.

## Revendications

1. Composant électronique (100), présentant un corps de base (1) qui présente un matériau poreux présentant des pores de surface (2) au niveau d'une surface (7) du corps de base (1),
un liquide de passivation (3) étant disposé dans les pores de surface (2),
des zones de surface (6) du corps de base (1), dans lesquelles ne se trouvent pas de pores de surface (2), étant exemptes de liquide de passivation (3) et le liquide de passivation protégeant les pores de surface (2) et/ou le corps de base (1) contre une pénétration de milieux ou de substances corrosifs ou nuisibles pour le corps de base (1) dans les pores de surface (2) ou, selon le cas, à l'intérieur du corps de base (1), le corps de base (1) étant une céramique frittée et le corps de base (1) étant pourvu d'une électrode externe (4).

2. Composant électronique (100) selon la revendication 1, dans lequel les diamètres des pores de surface (2) se situent dans la plage nanométrique.

3. Composant électronique (100) selon au moins l'une quelconque des revendications précédentes,
le liquide de passivation (3) agencé dans les pores de surface (2) empêchant ou compliquant la pénétration de substances étrangères, par exemple des solutions électrolytiques contenant du Ni et/ou du Sn, des fondants de soudure contenant des alcalis, comme des lessives de Na ou de K, et/ou des agents de protection contre l'abrasion, via les pores de surface (2) dans le corps de base (1).

4. Composant électronique (100) selon au moins l'une quelconque des revendications précédentes, le liquide de passivation (3) étant une solution inerte ou une solution quasiment inerte, par exemple de l'eau désionisée ou présentant un solvant non polaire.

5. Composant électronique (100) selon au moins l'une quelconque des revendications précédentes,
le liquide de passivation (3) présentant une résistance électrique spécifique entre 10 et 1000 kΩcm.

6. Composant électronique (100) selon au moins l'une quelconque des revendications précédentes,
des électrodes internes (5) étant disposées dans le corps de base (1) et les électrodes internes (5) étant électriquement séparées les unes des autres.

7. Composant électronique (100) selon au moins l'une quelconque des revendications précédentes,
le corps de base (1) étant pourvu d'électrodes externes (4) et les électrodes externes (4) étant électriquement séparées les unes des autres et chaque électrode externe (4) étant reliée de manière électriquement conductible à plusieurs électrodes internes (5).

8. Composant électronique (100) selon au moins l'une quelconque des revendications précédentes,
qui est un composant multicouche, par exemple une varistance, un composant piézoélectrique ou un condensateur.

9. Procédé pour la fabrication d'un composant électronique (100), présentant les étapes suivantes :
- frittage d'un corps cru prévu pour un corps de base (1) du composant, pour former le corps de base (1), le corps cru présentant un matériau fritté, poreux,
- disposition d'une électrode externe (4) sur le corps de base (1),
- passivation du corps de base (1) poreux, pourvu de l'électrode externe (4) par mise à disposition du corps de base (1) et par soumission des pores de surface (2) du matériau poreux du corps de base (1) à un liquide de passivation (3), le liquide de passivation (3) pénétrant et restant dans les pores de surface (2),
- traitement galvanique du corps de base (1) pourvu de l'électrode externe, activation de surface du matériau de l'électrode externe par traitement d'une surface du matériau de l'électrode externe par un fondant ou traitement du corps de base (1), du corps de base galvanisé (1) et/ou de l'électrode externe par des fondants de soudure et/ou des agents de protection contre l'abrasion,
- finition du composant électronique (100).

10. Procédé pour la fabrication selon la revendication 9, le traitement galvanique du corps de base (1) pourvu de l'électrode externe étant réalisé dans une solution électrolytique, contenant par exemple du nickel et de l'étain.

11. Procédé selon la revendication 9 ou 10,
les pores de surface (2) étant soumis au liquide de passivation (3) dans les conditions de la pression ambiante sans application d'une pression externe.

12. Procédé selon l'une quelconque des revendications 9 à 11,
les pores de surface (2) étant soumis au liquide de passivation (3) à température ambiante.
